Europäisches Patentamt

European Patent Office

Office européen des brevets

(19)

(11) **EP 1 265 255 B1**

(12) **EUROPÄISCHE PATENTSCHRIFT**

(45) Veröffentlichungstag und Bekanntmachung des Hinweises auf die Patenterteilung:
**16.03.2005 Patentblatt 2005/11**

(51) Int Cl.⁷: **G11C 29/00**

(21) Anmeldenummer: **02012628.0**

(22) Anmeldetag: **06.06.2002**

(54) **Verfahren und Vorrichtung zur Fehleranalyse von physikalischen Teilobjekten, welche in einem physikalischen Objekt in Form einer Matrix angeordnet sind, computerlesbares Speichermedium und Computerprogramm-Element**

Method and device for failure analysis of physical part objects which are arranged in a physical object in matrix form, computer readable storage medium and computer program element

Procédé et appareil d'analyse de défaillances d'objets physiques, qui sont disposés en forme de réseau matriciel, moyen de stockage lisible par ordinateur et élément de programme d'ordinateur

(84) Benannte Vertragsstaaten:
**FR GB IT**

(30) Priorität: **06.06.2001 DE 10127352**

(43) Veröffentlichungstag der Anmeldung:
**11.12.2002 Patentblatt 2002/50**

(73) Patentinhaber: **Infineon Technologies AG**
**81669 München (DE)**

(72) Erfinder:
• **Pöppel, Gerhard, Dr.**
**93049 Regensburg (DE)**

• **Krückl, Matthias**
**93051 Regensburg (DE)**

(74) Vertreter: **Viering, Jentschura & Partner**
**Steinsdorfstrasse 6**
**80538 München (DE)**

(56) Entgegenhaltungen:
**EP-A- 0 783 170        DE-A- 19 752 212**
**DE-A- 19 919 157        US-A- 6 154 861**

**Beschreibung**

Die Erfindung betrifft ein Verfahren und eine Vorrichtung zur Analyse von physikalischen Teilobjekten, welche in einem physikalischen Objekt in Form einer Matrix angeordnet sind, ein computerlesbares Speichermedium sowie ein Computerprogramm-Element.

Im Rahmen der datentechnischen Analyse von einem Speicherarray, d.h. von in einer Matrix angeordneten Speicherzellen, ist es bekannt, eine sogenannte Bitmap-Analyse durchzuführen, mittels der Rückschlüsse auf zugrundeliegende Fehlermechanismen von in dem Speicherarray auftretenden Fehlern gezogen werden.

Neben üblicherweise leicht erkennbaren und gut abgrenzbaren Fehlerklassen, beispielsweise Einzelbit-Fehlern, Doppelbit-Fehlern oder Kreuzungsfehlern treten oftmals systematische Fehlermuster in dem Speicherarray auf, deren Erkennung und Abgrenzung zu anderen Fehlerklassen relativ aufwendig ist.

Zur Ermittlung und Klassifizierung solcher systematischer Fehlermuster ist es bekannt, die erstellte Bitmap eines Speicherarrays datentechnisch zu analysieren. In der Bitmap ist üblicherweise in Form einer Matrix für jeweils eine Speicherzelle mittels eines binären Wertes (logisch "Null" oder logisch "Eins") jeweils angegeben, ob die Speicherzelle an der jeweiligen örtlichen Position innerhalb der Matrix funktionsfähig ist, d.h. als fehlerfrei getestet worden ist, oder nicht.

Die Bitmap-Analyse erfolgt üblicherweise zum Erkennen systematischer Fehlermuster mittels einer manuellen Nachbearbeitung oder mittels teilautomatisierter Klassifizierung, beispielsweise mittels Untersuchung von Zeilen-/Spalten-Summen auf regelmäßig auftretende Abstände und/oder systematisch auftretende Vielfache.

Ferner ist es in diesem Zusammenhang aus [1] bekannt, eine Fourier-Analyse der jeweils zu untersuchenden Bitmap durchzuführen, und aufgrund der ermittelten Spektralverteilung der Fehlerinformation in der Bitmap die jeweilige Fehlerklassifikation vorzunehmen.

Weiterhin ist aus der DE 197 52 212 A1 ein Fehleranalyse-Verfahren unter Verwendung einer diskreten Kosinus-Transformation bekannt, bei dem die Entwicklungskoeffizienten der diskreten Kosinus-Transformation zur Bestimmung der Störereignisanzahl verwendet werden.

Der Erfindung liegt das Problem zugrunde, eine Fehleranalyse von physikalischen Teilobjekten, welche in einem physikalischen Objekt in Form einer Matrix angeordnet sind, anzugeben, welche einfacher und genauer ist als die bekannten Fehleranalysen.

Das Problem wird durch das Verfahren und die Vorrichtung zur Fehleranalyse von physikalischen Teilobjekten, welche in einem physikalischen Objekt in Form einer Matrix angeordnet sind, das computerlesbare Speichermedium und das Computerprogramm-Element mit den Merkmalen gemäß den unabhängigen Patentansprüchen gelöst.

Bei einem Verfahren zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben, werden für die Fehlerdaten der Fehlerdatenmatrix Entwicklungskoeffizienten einer Analysetransformation der Fehlerdatenmatrix ermittelt. Die Analysetransformation ist dadurch charakterisiert, dass sie eine Orthogonal-Transformation mit einer binären Struktur in den Basisvektor-Komponenten der Basisvektoren der Analysetransformation ist. Unter Verwendung der ermittelten Entwicklungskoeffizienten der Analysetransformation wird die Fehleranalyse durchgeführt.

Eine Vorrichtung zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben, weist einen Prozessor auf, der derart eingerichtet ist, dass die oben beschriebenen Verfahrensschritte durchgeführt werden können.

Ein Computerprogramm-Element weist die oben beschriebenen Verfahrensschritte auf, nachdem es in einen Speicher eines Computers geladen worden ist und von einem Prozessor ausgeführt wird.

Auf einem computerlesbaren Speichermedium ist ein Computerprogramm gespeichert, das es einem Computer ermöglicht, nachdem es in einen Speicher des Computers geladen worden ist und von einem Prozessor ausgeführt wird, die oben beschriebenen Verfahrensschritte durchzuführen.

Anschaulich kann die Erfindung darin gesehen werden, dass zur Fehleranalyse von physikalischen Teilobjekten ein Maßsystem verwendet wird, welches dem Problem der systematischen Fehlerbilder in einer physikalischen Struktur mit zu einer Matrix angeordneten Zeilen und Spalten angepasst ist, in Analogie zu einem Speicherarray als physikalischem Objekt und einer Vielzahl von Speicherzellen als physikalische Teilobjekte. Anders ausgedrückt wird erfindungsgemäß ein Maßsystem zur Fehleranalyse verwendet, das zum Problem der systematischen Fehlerbilder in einer matrixförmigen Struktur, vorzugsweise einer Struktur eines Speicherarrays, optimiert angepasst ist, wodurch die Möglichkeit eröffnet wird, in einem Schritt zu beurteilen, ob und wie stark das vorhandene Speicherarray von einem systematischen Fehlermechanismus geprägt ist.

Anders ausgedrückt wird die Eigenschaft einer binären Adressierung und der Erkenntnis, dass vorwiegend Mischungen von Fehlerklassen auftreten, welche sich in $2^n$-Vielfachen Wiederholungen, bei der Anwendung der Erfindung für deren Fehleranalyse von Speicherarrays, dadurch ausgenutzt, dass eine Analyse-Transformation verwendet wird, die diesen Anforderungen optimal angepasst ist.

Bevorzugte Weiterbildungen der Erfindung ergeben sich aus den abhängigen Ansprüchen.

Die im Weiteren beschriebenen Ausgestaltungen der Erfindung betreffen sowohl das Verfahren, die Vorrichtung, das computerlesbare Speichermedium als auch das Computerprogramm-Element.

Das physikalische Objekt kann ein Speicherarray sein und das jeweilige physikalische Teilobjekt kann jeweils eine Speicherzelle des Speicherarrays oder ein Teil einer Speicherzelle des Speicherarrays ein.

Insbesondere für diesen Anwendungsfall hat sich die Anwendung einer Analysetransformation, welche charakterisiert ist durch eine Orthogonal-Transformation mit einer binären Struktur in den Basisvektor-Komponenten ihrer Basisvektoren als sehr exakt und schnell durchführbare Grundlage für die entsprechende Fehleranalyse herausgestellt.

Die Erfindung kann ferner beispielsweise eingesetzt werden zur Fehleranalyse von Fehlerkarten, mit denen fehlerhafte Chips auf einem Wafer repräsentiert werden. Allgemein kann die Erfindung sehr vorteilhaft eingesetzt werden für die Fehleranalyse von physikalischen Teilobjekten in einem physikalischen Objekt, bei denen eine überwiegend binäre Struktur vorliegt, analog zu einem Speicherarray.

Gemäß einer Ausgestaltung der Erfindung kann die Analysetransformation eine normierte Orthogonal-Transformation (Orthonormal-Transformation) mit einer binären Struktur in den Basisvektor-Komponenten der Basisvektoren der Analysetransformation sein.

Durch diese Ausgestaltung der Erfindung ist eine Normierung der zu verarbeitenden Werte vor oder nach der Transformation nicht mehr erforderlich.

Es ist jedoch in diesem Zusammenhang zu bemerken, dass eine entsprechende Normierung auch vor Durchführung der jeweiligen Analysetransformation oder nach erfolgter Analysetransformation vorgesehen sein kann.

Bevorzugt wird die Walsh-Transformation als Analysetransformation zur Fehleranalyse eingesetzt.

Die Walsh-Transformation zeichnet sich durch ihre Einfachheit und Exaktheit in den oben beschriebenen Anwendungsgebieten aus.

Gemäß einer weiteren Ausgestaltung der Erfindung werden die Quadrate der Entwicklungskoeffizienten der Analysetransformation ermittelt und unter Verwendung der ermittelten Quadrate wird die Fehleranalyse durchgeführt.

Gemäß einer weiteren Ausgestaltung der Erfindung wird unter Verwendung der ermittelten Quadrate der Entwicklungskoeffizienten der Analysetransformation die Entropie der Verteilung von Fehlern (Fehlerverteilung) der physikalischen Teilobjekte ermittelt und unter Verwendung der ermittelten Entropie wird die Fehleranalyse durchgeführt.

Die Entropie hat sich in den genannten Anwendungsfällen als ein sehr zuverlässiges, robustes und qualitativ hochwertiges Fehlermaß für die Fehleranalyse herausgestellt.

Unter Verwendung der ermittelten Quadrate des Entwicklungskoeffizienten der Analysetransformation kann eine empirische Entropie der Fehlerverteilung der physikalischen Teilobjekte ermittelt werden. Ferner kann unter Verwendung der ermittelten Quadrate der Entwicklungskoeffizienten der Analyse-Transformation eine analytische Entropie der Fehlerverteilung der physikalischen Teilobjekte ermittelt werden und abhängig von der ermittelten empirischen Entropie und der ermittelten analytischen Entropie kann die Fehleranalyse durchgeführt werden.

Mit dieser Vorgehensweise wird die Verlässlichkeit der Fehleranalyse weiter erhöht, insbesondere da ein empirischer Bezugspunkt, nämlich der der empirischen Entropie der Fehlerverteilung, als relatives Klassifikationskriterium verwendet wird.

Die empirische Entropie $S_{emp}$ der Fehlerverteilung der physikalischen Teilobjekte wird gemäß einer Ausgestaltung der Erfindung gemäß folgender Vorschrift ermittelt:

$$S_{emp} = -\sum_{i=2}^{N} \alpha_i^2 \cdot \ln\left(\alpha_i^2\right),$$

wobei mit

- i ein Laufindex,
- $\alpha_i^2$ das Quadrat des i-ten Entwicklungskoeffizienten der Analysetransformation, und
- N die Anzahl der berücksichtigten physikalischen Teilobjekte,

bezeichnet wird.

Gemäß einer weiteren Ausgestaltung der Erfindung, insbesondere für den Fall, dass $\alpha_1 = 0$ gilt, wird die analytische Entropie $S_{ana}$ der Fehlerverteilung der physikalischen Teilobjekte gemäß folgender Vorschrift ermittelt:

$$S_{ana} = -\left[(1-r)^2 \ln(1-r)^2 + (1-(1-r))^2 \cdot \ln \frac{1-(1-r)^2}{N-2} \cdot (2.074 + \eta)\right]$$

wobei mit

- r ein vorgebbarer Zufallsanteil mit $0 \leq r \leq 1$, mit der die Zufälligkeit der Fehlerverteilung angegeben wird,
- N die Anzahl der berücksichtigten physikalischen Teilobjekte, und
- $\eta$ ein vorgegebener Toleranzparameter,

bezeichnet wird.

Alternativ wird gemäß einer Weiterbildung der Erfindung, insbesondere für den Fall, dass $\alpha_1 \neq 0$ gilt, die analytische Entropie $S_{ana}$ der Fehlerverteilung der physikalischen Teilobjekte gemäß folgender Vorschrift ermittelt:

$$S_{ana} = -\left[f \cdot \alpha_{gen}^2 \cdot \ln\left(\alpha_{gen}^2\right) + (N-1-f) \cdot \alpha_{typ}^2 \cdot \ln\left(\alpha_{typ}^2 \cdot (2.074 + \eta)\right)\right]$$

mit

$$\alpha_{typ}^2 = \frac{\left(1-\alpha_1^2\right) \cdot \left(1-(1-r)^2\right)}{N-1-f},$$

$$\alpha_{gen}^2 = (1-r)^2 \cdot \frac{\left(1-\alpha_1^2\right)}{f},$$

$$\alpha_1 = (2 \cdot \delta - 1),$$

$$\delta = \frac{N_1}{N},$$

wobei mit

- $N_1$ die Anzahl fehlerhafter physikalischer Teilobjekte in dem physikalischen Objekt,
- r ein vorgebbarer Zufallsanteil mit $0 \leq r \leq 1$, mit der die Zufälligkeit der Fehlerverteilung angegeben wird,
- f die Zahl der Walsh-Pattern, die zum Generieren des Ausgangszustandes verwendet worden sind,
- N die Anzahl der berücksichtigten physikalischen Teilobjekte, und
- $\eta$ ein vorgegebener Toleranzparameter,

bezeichnet wird.

Unter Verwendung der ermittelten Quadrate der Entwicklungskoeffizienten der Analysetransformation kann eine Summe eines Teils der in ihren Werten aufsteigend geordneten Quadrate der Entwicklungskoeffizienten ermittelt werden.

Unter Verwendung der ermittelten Summe kann dann die Fehleranalyse durchgeführt werden.

Durch diese Ausgestaltung der Erfindung wird die Fehleranalyse weiter vereinfacht und somit schneller numerisch durchführbar.

Unter Verwendung der ermittelten Summe und einer weiteren Summe eines Teils der in ihren Werten aufsteigend geordneten Entwicklungskoeffizienten bei im wesentlichen völlig zufälliger Fehlerverteilung kann die Fehleranalyse noch verlässlicher durchgeführt werden.

Bevorzugt wird unter Verwendung der Fehleranalyse eine physikalische Analyse des physikalischen Objekts durchgeführt, wobei die Art und der Ort der physikalischen Analyse innerhalb des jeweiligen physikalischen Objekts, insbesondere des jeweiligen Speicherarrays, durch die Fehleranalyse, d.h. das Ergebnis der Fehleranalyse, bestimmt wird.

Durch die Fehleranalyse wird es somit möglich, die aufwendige physikalische Analyse insbesondere eines Speicherarrays optimiert und damit kostengünstig durchzuführen.

Ausführungsbeispiele der Erfindung sind in den Figuren dargestellt und werden im Weiteren näher erläutert.

Es zeigen:

Figur 1     eine Anordnung mit einem Chip-Test-System und einer Fehleranalyse-Vorrichtung gemäß einem Ausführungsbeispiel der Erfindung;

Figur 2     eine Darstellung einer Bitmap, in der für jede Speicherzelle eines Speicherarrays angegeben ist, ob die jeweilige Speicherzelle fehlerbehaftet oder fehlerfrei ist;

Figur 3     ein Ablaufdiagramm, in dem die einzelnen Verfahrensschritte des Verfahrens zur datentechnischen Fehleranalyse und anschließender physikalischen Überprüfung eines Chips gemäß einem Ausführungsbeispiel der Erfindung dargestellt sind; und

Figur 4     ein Ablaufdiagramm, in dem die einzelnen Verfahrensschritte des Verfahrens zur datentechnischen Fehleranalyse gemäß einem Ausführungsbeispiel der Erfindung dargestellt sind.

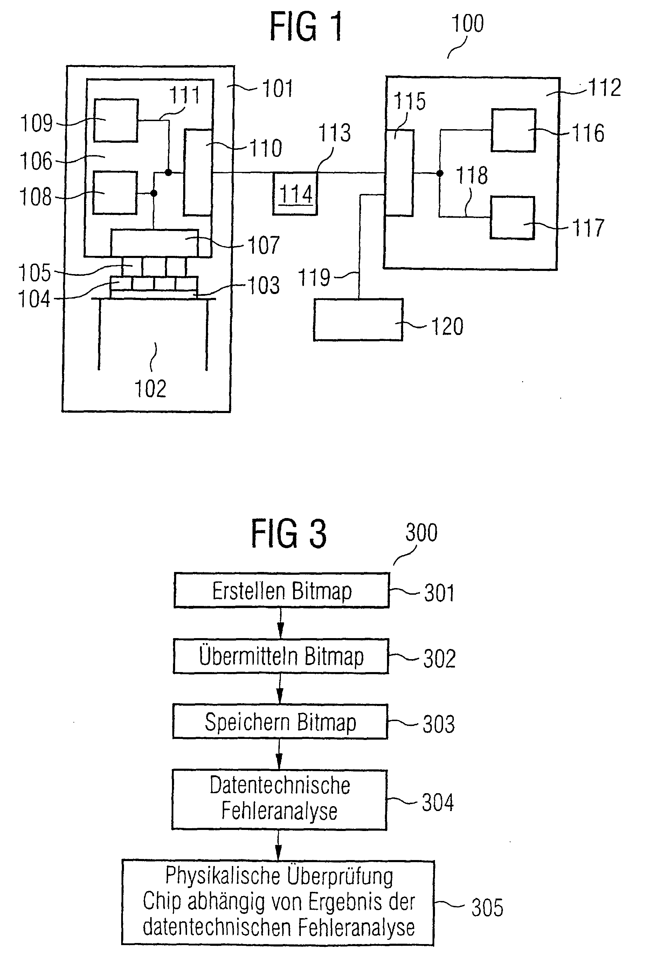

**Fig.1** zeigt in einem Blockdiagramm 100 eine Chip-Testanordnung 101, welche mit einem Fehleranalyse-Computer 112 gekoppelt ist.

Die Chip-Testanordnung 101 weist eine Wafer-Zuführeinrichtung 102 auf, gemäß diesem Ausführungsbeispiel ausgestaltet als ein Fließband, auf welcher Wafer-Zuführeinrichtung 102 elektronische Wafer 103 mit einer Vielzahl von elektronischen Chips 104 zum Testen der Funktionsfähigkeit der Chips 104 einem Chip-Test-Computer 106 zugeführt wird.

Mittels des Chip-Test-Computers 106 wird die Funktionstüchtigkeit der auf dem Wafer 103 vorhandenen Chips 104 gemäß vorgegebener Testroutinen geprüft.

Die vorgegebenen Testroutinen sind derart ausgestaltet, dass mit ihnen die vorgegebene Soll-Funktionalität des jeweiligen Chips 104 getestet wird, der von der Chip-Testanordnung 101 getestet werden soll.

Die zum Testen des Chips 104 jeweils erforderliche Testroutine ist als Computerprogramm in einem Speicher 108 in dem Chip-Test-Computer 106 gespeichert und wird von einem in dem Chip-Test-Computer 106 ebenfalls vorgesehenen Prozessor 109 ausgeführt.

Zum elektrischen Koppeln des Chip-Test-Computers 106 mit dem jeweiligen Chip 104 auf dem Wafer 103 sind elektrische Kontakte 105 vorgesehen, gemäß diesem Ausführungsbeispiel ausgestaltet als sogenannte Nadelkarten, mittels derer die elektronischen Chips 104 über deren Kontaktanschlüsse (Pads) mit einer Eingangs-/Ausgangsschnittstelle 107 des Chip-Test-Computers 106 gekoppelt sind.

Ferner weist der Chip-Test-Computer 106 eine weitere Eingangs-/Ausgangsschnittstelle 110 auf, mittels welcher der Chip-Test-Computer 106 mit dem Fehleranalyse-Computer 112 gekoppelt ist.

Der Speicher 108, der Prozessor 109, die Eingangs-/Ausgangsschnittstelle 107 und die weitere Eingangs-/Ausgangsschnittstelle 110 sind in dem Chip-Test-Computer 106 über einen Computerbus 111 miteinander gekoppelt.

Gemäß diesem Ausführungsbeispiel sind die Chips 104 als Speicherchips ausgestaltet, d.h. als ein Speicherarray mit einer Vielzahl von Speicherzellen, die in Zeilen und Spalten in Form einer Matrix angeordnet sind.

Ein solches Speicherarray ist beispielsweise

- ein DRAM,
- ein SRAM,
- ein SDRAM,
- ein ROM, oder
- ein weiterer beliebiger elektronischer Speicher.

Die Prüfung der Funktionsfähigkeit des Chips 104 entspricht gemäß diesem Ausführungsbeispiel der Überprüfung, ob die Speicherzellen des Speicherarrays fehlerfrei oder fehlerbehaftet sind.

Gemäß diesem Ausführungsbeispiel wird jedes Speicherarray in jedem Chip 104 und in dem Speicherarray jede Speicherzelle auf ihre Funktionsfähigkeit hin überprüft.

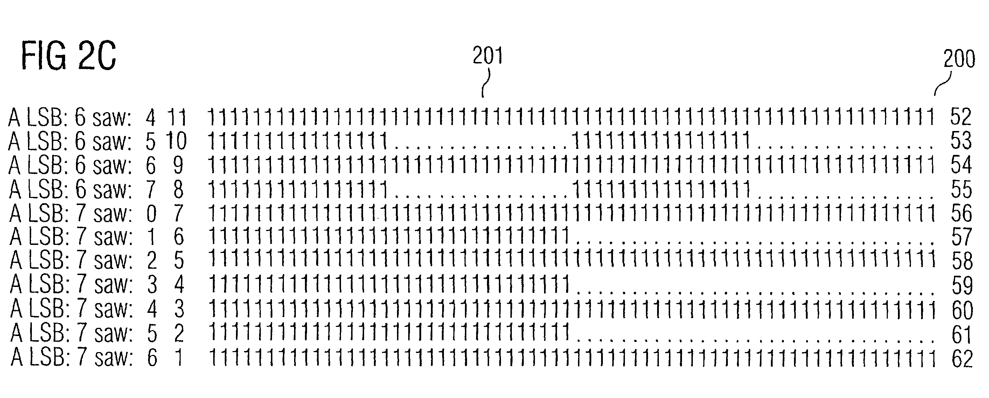

Unter Verwendung der entsprechenden Testroutinen wird für jedes Speicherarray eine sogenannte Bitmap, im weiteren auch bezeichnet als Fehlerkarte, erstellt (Schritt 301 in Ablaufdiagramm 300, vgl. **Fig.3**).

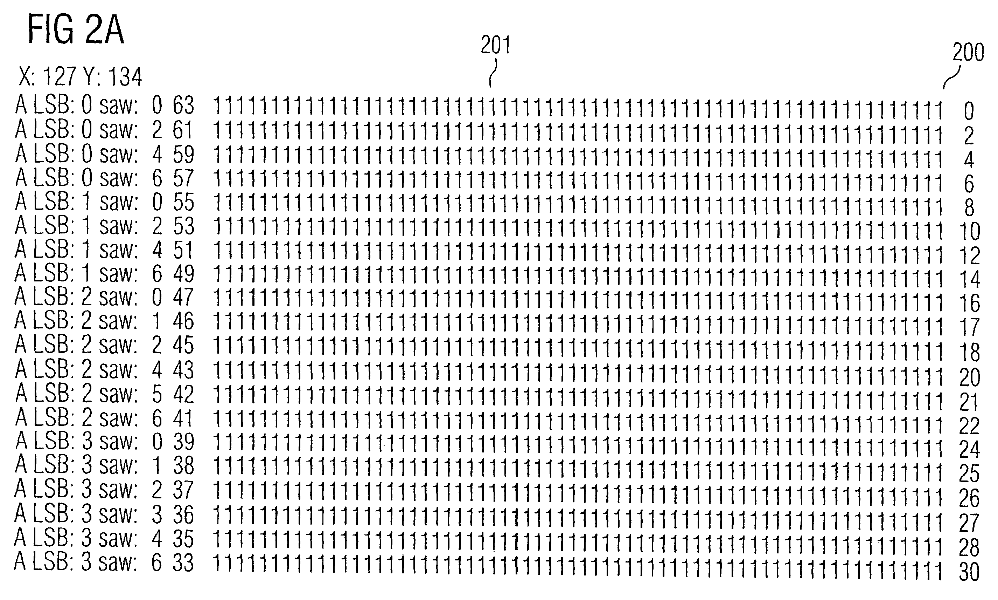

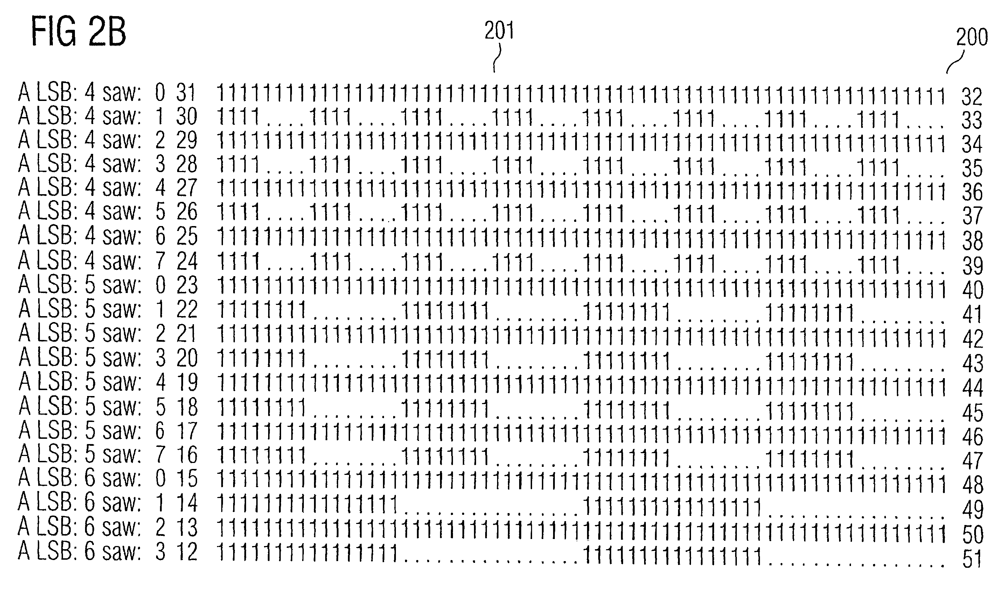

Die Fehlerkarte 200 (vgl. **Fig.2**) weist in ihrem Fehlerinformationsfeld 201 die Fehlerinformation, d.h. eine Angabe darüber, ob eine jeweilige Speicherzelle in dem getesteten Speicherarray fehlerbehaftet oder fehlerfrei ist, auf.

Gemäß diesem Ausführungsbeispiel ist eine fehlerfreie Speicherzelle durch einen ersten logischen Wert "1" repräsentiert.

In **Fig.2** ist eine fehlerbehaftete Speicherzelle durch einen einzelnen Punkt bezeichnet.

Das Fehlerinformationsfeld 201 enthält die jeweiligen Fehlerinformationen in einer Matrixform, d.h. in Zeilen und Spalten.

Anders ausgedrückt ist die jeweilige Fehlerinformation entsprechend der Struktur der Speicherzellen in dem Speicherarray in Zeilen und Spalten geordnet, wobei die relative örtliche Position der Fehlerinformation innerhalb des Fehlerinformationsfelds 201 der jeweiligen relativen örtlichen Position der zugehörigen Speicherzelle in dem entsprechenden physikalischen Speicherarray in dem Chip 104 auf dem Wafer 103 entspricht.

Die Fehlerkarte 200 wird von dem Chip-Test-Computer 106 über eine Kommunikationsverbindung 113 in einer Fehlerkarten-Nachricht 114 zu dem Fehleranalyse-Computer 112 übermittelt (Schritt 302) und dort über eine Eingangs-/Ausgangsschnittstelle 115 empfangen und in einem Speicher des Fehleranalyse-Computers 112 gespeichert (Schritt 303).

Ferner weist der Fehleranalyse-Computer 112 einen Prozessor 117 auf, von dem die im Weiteren beschriebene datentechnische Fehleranalyse durchgeführt wird (Schritt 304).

Das Verfahren der Fehleranalyse selbst, wie sie im Weiteren beschrieben ist, ist als Computerprogramm implementiert und in dem Speicher 116 des Fehleranalyse-Computers 112 gespeichert.

Die Eingangs-/Ausgangsschnittstelle 115, der Speicher 116 und der Prozessor 117 sind über einen Computerbus 118 miteinander gekoppelt.

Ferner ist über eine erste Verbindungsleitung 119 eine Anzeigeeinheit, gemäß diesem Ausführungsbeispiel ein Bildschirm 120 mit dem Fehleranalyse-Computer 112 verbunden.

Auf dem Bildschirm 120 werden die Fehleranalyseergebnisse einem Benutzer dargestellt.

Abhängig von dem Ergebnis der Fehleranalyse, welche mögliche Fehlermechanismen, die zum Auftreten der ermittelten Fehlermuster in der Fehlerkarte 200 führen, beschreiben, wird eine physikalische Überprüfung des fehlerhaften Chips 104 durchgeführt (Schritt 305), um die datentechnische ermittelte Fehleranalyse auch an dem physikalischen Objekt, d.h. dem Speicherarray selbst zu verifizieren und die ermittelten Fehler entsprechend abzustellen.

Die in **Fig.2** dargestellte Fehlerkarte 200 repräsentiert ein ermitteltes Beispiel für eine fehlerhafte Adressleitung in der Ansteuerschaltung des Speicherarrays.

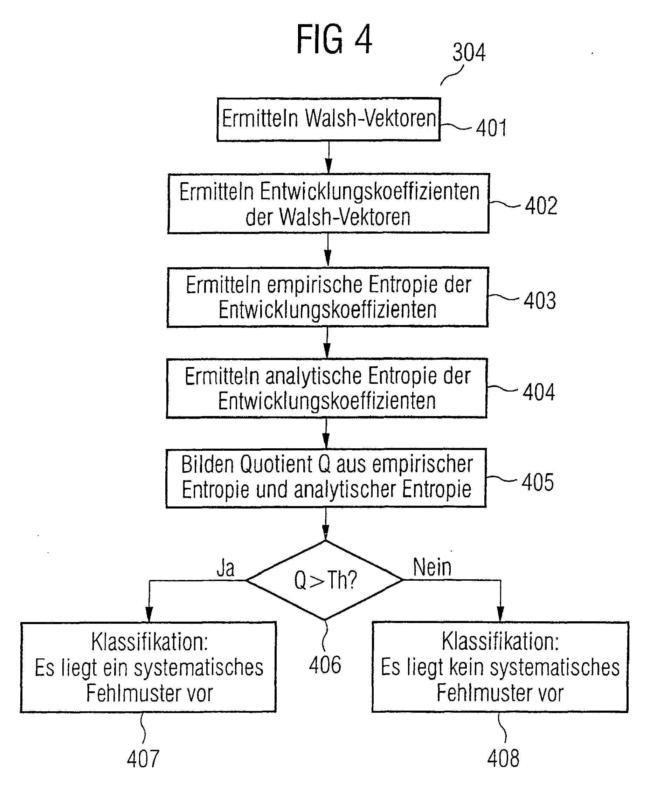

Im Weiteren wird das auf jede Fehlerkarte 200 angewendete Verfahren zur Fehleranalyse im Detail beschrieben (vgl. Ablaufdiagramm 304 in **Fig.4**).

Es wird erfindungsgemäß ein Maßsystem verwendet, welches dadurch gewonnen wird, dass das Speicherarray und damit die Fehlerkarte 200 als ein Vektor aufgefasst wird, welcher Vektor nach Walsh-(Hadamard)-Vektoren entwickelt wird.

Das durch Walsh-Hadamard-Vektoren ausgebildete System ist ein Orthonormalsystem, was dazu führt, dass die Zerlegung der Vektoren zur Bildung des Orthonormalsystems eindeutig ist.

Die entwickelten Walsh-Vektoren werden für eine im Weiteren beschriebene Analysetransformation verwendet.

Erfindungsgemäß wurde erkannt, dass dieses Orthonormalsystem, welches unter Verwendung der Walsh-Vektoren gebildet wird, dasjenige Orthonormalsystem ist, das dem internen regelmäßigen $2^n$-Aufbau eines Speicherarrays und dessen Adressierung optimal Rechnung trägt.

Für die weitere mathematische Veranschaulichung wird abweichend von der Nomenklatur aus **Fig.2** das Speicherarray als ein Speichervektor $\underline{t}$ bezeichnet, wobei der Speichervektor $\underline{t}$ in seinen Komponenten einen Wertebereich von 2 Werten aufweist, d.h. einen binären Wertebereich, gemäß diesem Ausführungsbeispiel einen Wertebereich mit einem ersten binären Wert "-1", mit dem angegeben wird, dass die jeweilige Speicherzelle fehlerfrei ist und einem zweiten binären Wert "1", mit dem angegeben wird, dass die entsprechende Speicherzelle fehlerbehaftet ist.

Mit $\underline{w}_i$ wird der i-te Walsh-Vektor bezeichnet.

Der jeweilige i-te Entwicklungskoeffizient $\alpha_i$ der Walsh-Zerlegung, auch bezeichnet als "Walsh-Pattern" ergibt sich gemäß folgender Vorschrift, wobei $\underline{t}$ und $\underline{w}_i$ N-komponentige Vektoren sind:

$$\alpha_i = \frac{1}{N} \cdot \underline{t} \cdot \underline{w}_i . \tag{1}$$

Im Weiteren wird eine kurze Übersicht über Walsh-Vektoren und deren Entwicklung gegeben.

Walsh-Vektoren bestehen aus den Elementen [-1,1], sind orthogonal zueinander und gleich normiert.

Zur vollständigen Beschreibung N-komponentiger Walsh-Patterns benötigt man die N zueinander orthogonalen N-komponentigen Walsh-Vektoren, die beispielsweise wie folgt konstruiert werden können:

$N = 2$:

$$\underline{w}_1 = (+\ 1,+1)$$
$$\underline{w}_2 = (+\ 1,-1)$$

$$(2)$$

$N = 4$:

$$\underline{w}_1 = (+\ 1,+1,+1,+1)$$
$$\underline{w}_2 = (+\ 1,-1,+1,-1)$$
$$\underline{w}_3 = (+\ 1,+1,-1,-1)$$
$$\underline{w}_4 = (+\ 1,-1,-1,+1)$$

$$(3)$$

$N = 8$:

$$\underline{w}_1 = (+\ 1,+1,+1,+1,+1,+1,+1,+1)$$
$$\underline{w}_2 = (+\ 1,-1,+1,-1,+1,-1,+1,-1)$$
$$\underline{w}_3 = (+\ 1,+1,-1,-1,+1,+1,-1,-1)$$
$$\underline{w}_4 = (+\ 1,-1,-1,+1,+1,-1,-1,+1)$$
$$\underline{w}_5 = (+\ 1,+1,+1,+1,-1,-1,-1,-1)$$
$$\underline{w}_6 = (+\ 1,-1,+1,-1,-1,+1,-1,+1)$$
$$\underline{w}_7 = (+\ 1,+1,-1,-1,-1,-1,+1,+1)$$
$$\underline{w}_8 = (+\ 1,-1,-1,+1,-1,+1,+1,-1)$$

$$(4)$$

Es wird also in einem ersten Schritt (Schritt 401) für den Speichervektor $\underline{t}$ eine Zerlegung von Walsh-Vektoren $\underline{w}_i$ ermittelt.

Anschließend werden unter Verwendung von Vorschrift (1) die Entwicklungskoeffizienten $\alpha_i$ zu den ermittelten Walsh-Vektoren $\underline{w}_i$ bestimmt (Schritt 402).

Die Entwicklungskoeffizienten $\alpha_i$ enthalten die Information, welches grundlegende systematische Walsh-Pattern für das Fehlerbild, welches den jeweiligen Fehlermechanismus beschreibt, wie und wie stark beiträgt.

Es ist in diesem Zusammenhang anzumerken, dass dadurch, dass ein Orthonormalsystem verwendet wird, zugleich die Eigenschaft gewährleistet ist, dass die Quadratsumme der Entwicklungskoeffizienten $\alpha_i$ immer den Wert 1 ergibt.

Diese Eigenschaft wird erfindungsgemäß dazu verwendet, dass die Quadrate der Entwicklungskoeffizienten gemäß diesem Ausführungsbeispiel als Wahrscheinlichkeiten interpretiert werden.

Auf diese Weise kann gezeigt werden, dass die Verteilung der Entwicklungskoeffizienten $\alpha_i$ darüber Auskunft gibt, ob und wie viele systematische Effekte das Fehlerbild der Fehlerkarte 200 zusammensetzen.

Würden die in dem Speicherarray vorkommenden Fehler vollkommen zufällig verteilt sein, so gäbe es keine besonders bevorzugten Walsh-Vektoren und damit auch keine von einem Mittelwert erheblich abweichenden und damit bevorzugten Entwicklungskoeffizienten $\alpha_i$. Vielmehr würden die Entwicklungskoeffizienten $\alpha_i$ entsprechend näherungsweise einer Gaussverteilung ergeben.

Unter Verwendung der Interpretation der Quadrate der Walsh-Koeffizienten als Wahrscheinlichkeiten werden diese mit Hilfe der Mischungsentropie bezüglich der Walsh-Pattern untersucht, wobei die Entropie als ein Maß für die Zufälligkeit bzw. Nichtzufälligkeit (Determiniertheit) der Verteilung der Quadrate $\alpha_i^2$ der Entwicklungskoeffizienten $\alpha_i$ verwendet wird.

Die Mischungsentropie ist betragsmäßig maximal bei vollständig zufälliger Verteilung der Fehler über das gesamte Speicherarray hinweg und minimal bei einer vollständig deterministischen Systematik der Fehler.

Der Wert der Mischungsentropie und damit der Grad der Zufälligkeit wird im folgenden analytisch hergeleitet und im Vergleich mit den ebenfalls empirisch ermittelten Werten der Mischungsentropie herangezogen, um zu einem Ergebnis der Fehleranalyse zu gelangen.

Der Wert der empirischen Entropie $S_{emp}$ der Entwicklungskoeffizienten $\alpha_i$ der Walsh-Zerlegung (d.h. allgemein der Analysetransformation) wird gemäß folgender Vorschrift aus den Entwicklungskoeffizienten $\alpha_i$ (Walsh-Koeffizienten) ermittelt (Schritt 403):

$$S_{emp} = -\sum_{i=2}^{N} \alpha_i^2 \cdot \ln\left(\alpha_i^2\right), \tag{5}$$

wobei mit

- $\quad$ i ein Laufindex,
- $\quad$ $\alpha_i^2$ das Quadrat des i-ten Entwicklungskoeffizienten der Analysetransformation,
- $\quad$ N die Anzahl der berücksichtigten physikalischen Teilobjekte,

bezeichnet wird.

Im Weiteren wird zur Verdeutlichung der Ermittlung der analytischen Entropie $S_{ana}$ eine Herleitung der analytischen Entropie $S_{ana}$ der Entwicklungskoeffizienten $\alpha_i$ der Walsh-Zerlegung (d.h. allgemein der Analysetransformation) angegeben:

Um die analytische Entropie $S_{ana}$ zu ermitteln (Schritt 404), ist es erforderlich, folgendes Integral zu berechnen:

$$2 \cdot \int_{0}^{\infty} \varepsilon^2 \ln\left(\varepsilon^2\right) P(\varepsilon) d\varepsilon = \int_{-\infty}^{\infty} \varepsilon^2 \ln\left(\varepsilon^2\right) P(\varepsilon) d\varepsilon, \tag{6}$$

mit

$$P(\varepsilon) = \frac{1}{\sqrt{2 \cdot \pi \cdot \sigma^2}} e^{-\frac{1}{2} \cdot \frac{\varepsilon^2}{\sigma^2}}. \tag{7}$$

Zur Berechnung des Integrals gemäß Vorschrift (6) wird folgender Zusammenhang verwendet:

$$\ln(x) = \lim_{n \to 0} \frac{x^n - 1}{n}. \tag{8}$$

Unter Verwendung von Vorschrift (8) ergibt sich:

$$\int_{-\infty}^{\infty} \varepsilon^2 \ln(\varepsilon^2) P(\varepsilon) d\varepsilon = \int_{-\infty}^{\infty} \varepsilon^2 \lim_{n \to 0} \frac{(\varepsilon^2)^n - 1}{n} P(\varepsilon) d\varepsilon =$$

$$= \lim_{n \to 0} \int_{-\infty}^{\infty} \frac{1}{n} \left( \varepsilon^{2n+2} - \varepsilon^2 \right) P(\varepsilon) d\varepsilon = \tag{9}$$

$$= \lim_{n \to 0} \left( \frac{1}{n} \int_{-\infty}^{\infty} \varepsilon^{2n+2} P(\varepsilon) d\varepsilon - \frac{1}{n} \int_{-\infty}^{\infty} \varepsilon^2 P(\varepsilon) d\varepsilon \right)$$

Bei einer vorliegenden Gauss-Verteilung gilt folgende Vorschrift:

$$\langle x^k \rangle = \begin{cases} \dfrac{(k-1)}{2^{\left(\frac{k}{2}-1\right)} \cdot \left(\frac{k}{2}-1\right)!} \cdot \sigma^k, & \text{für } k \text{ gerade Zahl} \\[2em] 0, & \text{sonst} \end{cases} \tag{10}$$

Mit k = 2n + 2 gilt:

$$\langle \varepsilon^{2n+2} \rangle = \frac{(2n+1)}{2^n \cdot n!} \cdot \sigma^{2n+2}. \tag{11}$$

Da die Funktion der Fakultät (!) nur für ganzzahlige Objekte definiert ist, wird aufgrund der Grenzwertbetrachtung $n \to 0$ die analytische Fortsetzung benötigt, anders ausgedrückt also die Gamma-Funktion, die im Weiteren gemäß dieser Beschreibung wie folgt definiert ist:

$$n! = \Gamma(n+1). \tag{12}$$

Unter Verwendung von Vorschrift (12) ergibt sich:

$$\frac{(2n+1)}{2^n \cdot n!} = \frac{\Gamma(2n+2)}{2^n \cdot \Gamma(n+1)}. \tag{13}$$

Somit ergibt sich unter Verwendung von Vorschrift (13) für den Grenzwert ($n \to 0$) für das Integral gemäß Vorschrift (6):

$$\lim_{n\to 0}\left(\frac{1}{n}\int_{-\infty}^{\infty}\varepsilon^{2n+2}P(\varepsilon)d\varepsilon - \frac{1}{n}\int_{-\infty}^{\infty}\varepsilon^{2}P(\varepsilon)d\varepsilon\right) =$$

$$= \lim_{n\to 0}\left(\frac{1}{n}\frac{\Gamma(2n+2)}{2^{n}\cdot\Gamma(n+1)}\cdot\sigma^{2n+2} - \frac{1}{n}\cdot\sigma^{2}\right) =$$

$$= \sigma^{2}\lim_{n\to 0}\frac{1}{n}\left(\frac{\Gamma(2n+2)}{2^{n}\cdot\Gamma(n+1)}\cdot\sigma^{2n} - 1\right) =$$

$$= \sigma^{2}\lim_{n\to 0}\frac{\left[\left(\frac{\Gamma(2n+2)}{2^{n}\cdot\Gamma(n+1)}\right)^{\frac{1}{n}}\cdot\sigma^{2}\right]^{n} - 1}{n} =$$

$$= \sigma^{2}\cdot\ln\left[\left(\lim_{n\to 0}\gamma(n)\cdot\sigma^{2}\right)\right] \tag{14}$$

Der Wert für

$$\lim_{n\to 0}\gamma(n)$$

ergibt sich gemäß folgender Vorschrift, wobei zu bemerken ist, dass die Grenzwertermittlung ($n \to 0$) numerisch ermittelt worden ist.

$$\lim_{n\to 0}\gamma(n) = \sqrt[n]{\frac{\Gamma(2n+2)}{2^{n}\cdot\Gamma(n+1)}}^{\,n\to 0} = \sqrt[n]{\frac{\Gamma(2n+2)}{\cdot\Gamma(n+1)}}\cdot\frac{1}{2}^{\,n\to 0} = 2{,}074\,. \tag{15}$$

Damit ergibt sich unter Verwendung der Vorschriften (14) und (15) :

$$\sigma^{2}\cdot\ln\left[\left(\lim_{n\to 0}\gamma(n)\cdot\sigma^{2}\right)\right] = \sigma^{2}\cdot\ln\left[\left(2{,}074\cdot\sigma^{2}\right)\right]. \tag{16}$$

Damit ergibt sich für die analytische Entropie (für N >> 1) :

$$S = -N\cdot\sigma^{2}\cdot\ln\left[\left(2{,}074\cdot\sigma^{2}\right)\right]. \tag{17}$$

In diesem Zusammenhang ist anzumerken, dass die Vorschrift (17) gilt für den Fall, dass das Quadrat des

ersten Entwicklungskoeffizienten $\alpha_1^2$ den Wert 0 aufweist, d.h. dass gilt:

$$\alpha_1^2 = 0. \tag{18}$$

Für die analytische Entropie $S_{ana}$ ergibt sich in diesem Fall:

$$S_{ana} = -\left[(1 - r)^2 \ln(1 - r)^2 + (1 - (1 - r))^2 \cdot \ln \frac{1 - (1 - r)^2}{N - 2} \cdot (2.074 + \eta)\right] \tag{19}$$

wobei mit

- r ein vorgebbarer Zufallsanteil mit $0 \le r \le 1$, mit der die Zufälligkeit der Fehlerverteilung angegeben wird,
- N die Anzahl der berücksichtigten physikalischen Teilobjekte, und
- $\eta$ ein vorgegebener Toleranzparameter,

bezeichnet wird.

Für den Fall, dass der erste Entwicklungskoeffizient $\alpha_1^2$ nicht den Wert 0 aufweist, d.h. für den Fall, dass gilt:

$$\alpha_1^2 \ne 0, \tag{20}$$

ergibt sich für die analytische Entropie $S_{ana}$ folgende Vorschrift:

$$S_{ana} = -\left[f \cdot \alpha_{gen}^2 \cdot \ln\left(\alpha_{gen}^2\right) + (N - 1 - f) \cdot \alpha_{typ}^2 \cdot \ln\left(\alpha_{typ}^2 \cdot (2.074 + \eta)\right)\right] \tag{21}$$

mit

$$\alpha_{typ}^2 = \frac{\left(1 - \alpha_1^2\right) \cdot \left(1 - (1 - r)^2\right)}{N - 1 - f}, \tag{22}$$

$$\alpha_{gen}^2 = (1 - r)^2 \cdot \frac{\left(1 - \alpha_1^2\right)}{f}, \tag{23}$$

$$\alpha_1 = (2 \cdot \delta - 1), \tag{24}$$

$$\delta = \frac{N_1}{N}, \tag{25}$$

wobei mit

- N$_1$ die Anzahl fehlerhafter physikalischer Teilobjekte in dem physikalischen Objekt,
- r ein vorgebbarer Zufallsanteil mit $0 \leq r \leq 1$, mit der die Zufälligkeit der Fehlerverteilung angegeben wird,
- f die Zahl der Walsh-Pattern, die zum Generieren des Ausgangszustandes verwendet worden sind,
- N die Anzahl der berücksichtigten physikalischen Teilobjekte, und
- η ein vorgegebener Toleranzparameter,

bezeichnet wird.

Nachdem sowohl der Wert für die empirische Entropie S$_{emp}$ als auch für die analytische Entropie S$_{ana}$ ermittelt worden ist, wird ein Entropie-Quotient Q gebildet gemäß folgender Vorschrift (Schritt 405):

$$Q = \frac{S_{emp}}{S_{ana}} \, . \tag{26}$$

Für den Fall, dass der Entropie-Quotient Q größer ist als ein vorgegebener Schwellenwert Th, was überprüft wird in einem Prüfschritt (Schritt 406), d.h. für den Fall, dass gilt:

$$Q > Th, \tag{27}$$

wird klassifiziert, dass in der Fehlerkarte 200 ein systematisches Fehlermuster vorliegt und damit, dass ein systematischer Fehlermechanismus in dem Speicherarray, welches der Fehlerkarte zugrunde liegt, aufgetreten ist (Schritt 407).

Für den Fall, dass der Entropie-Quotient Q kleiner oder gleich ist als der vorgegebene Schwellenwert Th, wird klassifiziert, dass in der Fehlerkarte 200 kein systematisches Fehlermuster vorliegt und damit, dass kein systematischer Fehlermechanismus in dem Speicherarray, welches der Fehlerkarte zugrunde liegt, aufgetreten ist (Schritt 408).

Der Schwellenwert Th ist gemäß diesem Ausführungsbeispiel als Wert 0,70 gewählt.

Gemäß diesem Ausführungsbeispiel kommt folgender Fehlermechanismus in Betracht, welcher zu systematischen Fehlermustern in der Fehlerkarte 200 führt, die mit dem oben beschriebenen Verfahren erkannt werden können:

Eine oder mehrere fehlerhafte Adressleitungen in der Ansteuerschaltung des Speicherarrays.

Es ist in diesem Zusammenhang anzumerken, dass der Einsatz und die Ermittlung der analytischen Entropie S$_{ana}$ in Zusammenhang mit der empirischen Entropie S$_{emp}$ nicht auf die beschriebene Anwendung zur Auswertung von Entwicklungskoeffizienten α$_i$ von Walsh-Patterns beschränkt ist.

Vielmehr kann dieser Ansatz für die Auswertung beliebig vorliegender Wertemuster und damit beliebiger Entwicklungskoeffizienten auch von anderen Analysetransformationen eingesetzt werden.

Alternativ zum Ansatz von Entropien zur Auswertung der Entwicklungskoeffizienten α$_i$ zur Fehleranalyse der Fehlerkarten 200 kann folgendes Verfahren eingesetzt werden:

Die Abschätzung, ob es sich um ein systematisches Fehlermuster handelt, kann über eine Teilsumme der aufsteigend geordneten Quadrate der Entwicklungskoeffizienten α$_i$ erfolgen.

Da die Gesamtsumme der Walsh-Koeffizienten den Wert 1 ergibt und insbesondere systematische Muster in den Entwicklungskoeffizienten α$_i$ zu erhöhten Werten führen, führt das direkt zu einer Reduktion der restlichen Entwicklungskoeffizienten mit geringeren Werten und damit auch zu einer geordneten kumulierten Teilsumme Q' (beispielsweise bis zu 75 % aller Entwicklungskoeffizienten α$_i$).

Es existiert ein einfacher Zusammenhang zwischen der kumulierten Teilsumme Q' und dem Zufallsgrad des untersuchten Musters, gemäß diesem Ausführungsbeispiel der Fehlerkarte 200.

Bekannt muss lediglich zusätzlich der Wert der Teilsumme bei angenommener vollständiger Zufälligkeit der Fehlerverteilung in dem Speicherarray sein.

Dieser wird durch entsprechende Simulation, d.h. einer simulierten vollständig zufällig verteilten Fehlermenge über ein Speicherarray ermittelt.

Der Zufallsanteil r ergibt sich gemäß folgender Vorschrift:

$$r = 1 - \sqrt{1 - \frac{Q'}{Q''}} \tag{28}$$

wobei mit

- Q' die geordnete kumulierte Teilsumme der Entwicklungskoeffizienten bis zu einem vorgegebenen Schwellenwert, und
- Q" der Wert der geordnet kumulierten Teilsumme bei angenommener vollständiger Zufälligkeit der Fehlerverteilung,

bezeichnet wird.

Sind die den Fehlermustern entsprechenden Fehlermechanismen ermittelt worden, so werden ein oder mehrere Chips 104 auf dem jeweilig geprüften Wafer 103 physikalisch geprüft und es werden die ermittelten Fehlermechanismen an dem physikalischen Objekt verifiziert.

Anschließend werden möglicherweise ermittelte Fehlerursachen in der Prozesstechnologie oder in anderen Herstellungsschritten entsprechend verändert, um die ermittelten Fehlermechanismen zu beheben.

In diesem Dokument ist folgende Veröffentlichung zitiert:

[1] EP 0 783 170 A1.

**Bezugszeichenliste**

100 - Chip-Fehleranalyse-Anordnung
101 - Chip-Test-Anordnung
102 - Wafer-Zuführeinrichtung
103 - Wafer
104 - Chip
105 - Nadelkarte
106 - Chip-Test-Computer
107 - Eingangs-/Ausgangsschnittstelle
108 - Speicher
109 - Prozessor
110 - Weitere Eingangs-/Ausgangsschnittstelle
111 - Computerbus
112 - Fehleranalyse-Computer
113 - Kommunikationsverbindung
114 - Fehlerkarte
115 - Eingangs-/Ausgangsschnittstelle Fehleranalyse-Computer
116 - Speicher
117 - Prozessor
118 - Computerbus
119 - Kabel
120 - Bildschirm

200 - Fehlerkarte
201 - Fehlerinformationsfeld

300 - Ablaufdiagramm
301 - Erstellen Bitmap
302 - Übermitteln Bitmap
303 - Speichern Bitmap
304 - Datentechnische Fehleranalyse
305 - Physikalische Überprüfung Chip abhängig von Ergebnis der datentechnischen Fehleranalyse

401 - Ermitteln Walsh-Vektoren
402 - Ermitteln Entwicklungskoeffizienten der Walsh-Vektoren
403 - Ermitteln empirische Entropie der Entwicklungskoeffizienten
404 - Ermitteln analytische Entropie der Entwicklungskoeffizienten
405 - Bilden Quotient Q aus empirischer Entropie und analytischer Entropie
406 - Prüfschritt
407 - Klassifikation: Es liegt ein systematisches Fehlermuster vor

408 -    Klassifikation: Es liegt kein systematisches Fehlermuster vor

**Patentansprüche**

1. Verfahren zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben,

   - bei dem für die Fehlerdaten der Fehlerdatenmatrix Entwicklungskoeffizienten einer Analysetransformation der Fehlerdatenmatrix ermittelt werden,
   - wobei die Analysetransformation eine Orthogonal-Transformation mit einer binären Struktur in den Basisvektor-Komponenten der Basisvektoren der Analysetransformation ist,
   - bei dem unter Verwendung der ermittelten Entwicklungskoeffizienten der Analysetransformation die Fehleranalyse durchgeführt wird, wobei
   - unter Verwendung der ermittelten Entwicklungskoeffizienten der Analysetransformation ein Maß für die Zufälligkeit der Verteilung der Fehler der physikalischen Teilobjekte ermittelt wird und
   - unter Verwendung des Maßes für die Zufälligkeit der Verteilung der Fehler der physikalischen Teilobjekte bestimmt wird, ob ein systematisches Fehlermuster vorliegt.

2. Verfahren nach Anspruch 1,

   - bei dem das physikalische Objekt ein Speicherarray ist, und
   - ein physikalisches Teilobjekt jeweils eine Speicherzelle des Speicherarrays oder ein Teil einer Speicherzelle des Speicherarrays ist.

3. Verfahren nach Anspruch 1 oder 2,
   bei dem die Analysetransformation eine normierte Orthogonal-Transformation mit einer binären Struktur in den Basisvektor-Komponenten der Basisvektoren der Analysetransformation ist.

4. Verfahren nach einem der Ansprüche 1 bis 3,
   bei dem als Analysetransformation die Walsh-Transformation verwendet wird.

5. Verfahren nach einem der Ansprüche 1 bis 4,

   - bei dem die Quadrate der Entwicklungskoeffizienten der Analysetransformation ermittelt werden,
   - bei dem unter Verwendung der ermittelten Quadrate der Entwicklungskoeffizienten der Analysetransformation die Fehleranalyse durchgeführt wird.

6. Verfahren nach Anspruch 5,

   - bei dem unter Verwendung der ermittelten Quadrate der Entwicklungskoeffizienten der Analysetransformation die Entropie der Fehlerverteilung der physikalischen Teilobjekte ermittelt wird,
   - bei dem unter Verwendung der ermittelten Entropie die Fehleranalyse durchgeführt wird.

7. Verfahren nach Anspruch 6,

   - bei dem unter Verwendung der ermittelten Quadrate der Entwicklungskoeffizienten der Analysetransformation eine empirische Entropie der Fehlerverteilung der physikalischen Teilobjekte ermittelt wird,
   - bei dem unter Verwendung der ermittelten Quadrate der Entwicklungskoeffizienten der Analysetransformation eine analytische Entropie der Fehlerverteilung der physikalischen Teilobjekte ermittelt wird,
   - bei dem abhängig von der ermittelten empirischen Entropie und der ermittelten analytischen Entropie die Fehleranalyse durchgeführt wird.

8. Verfahren nach Anspruch 7,
   bei dem die empirische Entropie $S_{emp}$ der Fehlerverteilung der physikalischen Teilobjekte gemäß folgender Vorschrift ermittelt wird:

$$S_{emp} = -\sum_{i=2}^{N} \alpha_i^2 \cdot \ln\!\left(\alpha_i^2\right),$$

wobei mit

- i ein Laufindex,
- $\alpha_i^2$ das Quadrat des i-ten Entwicklungskoeffizienten der Analysetransformation,
- N die Anzahl der berücksichtigten physikalischen Teilobjekte,

bezeichnet wird.

**9.** Verfahren nach Anspruch 7 oder 8,
bei dem die analytische Entropie $S_{ana}$ der Fehlerverteilung der physikalischen Teilobjekte gemäß folgender Vorschrift ermittelt wird:

$$S_{ana} = -\left[(1-r)^2 \ln(1-r)^2 + (1-(1-r))^2 \cdot \ln \frac{1-(1-r)^2}{N-2} \cdot (2.074 + \eta)\right]$$

wobei mit

- r ein vorgebbarer Zufallsanteil mit $0 \le r \le 1$, mit der die Zufälligkeit der Fehlerverteilung angegeben wird,
- N die Anzahl der berücksichtigten physikalischen Teilobjekte, und
- $\eta$ ein vorgegebener Toleranzparameter,

bezeichnet wird.

**10.** Verfahren nach Anspruch 7 oder 8,
bei dem die analytische Entropie $S_{ana}$ der Fehlerverteilung der physikalischen Teilobjekte gemäß folgender Vorschrift ermittelt wird:

$$S_{ana} = -\left[f \cdot \alpha_{gen}^2 \cdot \ln\!\left(\alpha_{gen}^2\right) + (N-1-f) \cdot \alpha_{typ}^2 \cdot \ln\!\left(\alpha_{typ}^2 \cdot (2.074 + \eta)\right)\right]$$

mit

$$\alpha_{typ}^2 = \frac{\left(1 - \alpha_1^2\right) \cdot \left(1 - (1-r)^2\right)}{N - 1 - f},$$

$$\alpha_{gen}^2 = (1-r)^2 \cdot \frac{\left(1 - \alpha_1^2\right)}{f},$$

$$\alpha_1 = (2 \cdot \delta - 1),$$

$$\delta = \frac{N_1}{N},$$

wobei mit

- $N_1$ die Anzahl fehlerhafter physikalischer Teilobjekte in dem physikalischen Objekt,
- r ein vorgebbarer Zufallsanteil mit $0 \leq r \leq 1$, mit der die Zufälligkeit der Fehlerverteilung angegeben wird,
- f die Zahl der Walsh-Pattern, die zum Generieren des Ausgangszustandes verwendet worden sind,
- N die Anzahl der berücksichtigten physikalischen Teilobjekte, und
- $\eta$ ein vorgegebener Toleranzparameter,

bezeichnet wird.

**11.** Verfahren nach Anspruch 5,

- bei dem unter Verwendung der ermittelten Quadrate der Entwicklungskoeffizienten der Analysetransformation eine Summe eines Teils der in ihren Werten aufsteigend geordneten Quadrate der Entwicklungskoeffizienten ermittelt wird
- bei dem unter Verwendung der ermittelten Summe die Fehleranalyse durchgeführt wird.

**12.** Verfahren nach Anspruch 11,
bei dem unter Verwendung der ermittelten Summe und einer weiteren Summe eines Teils der in ihren Werten aufsteigend geordneten Quadrate der Entwicklungskoeffizienten bei im Wesentlichen vollständiger Zufälligkeit der Fehlerverteilung die Fehleranalyse durchgeführt wird.

**13.** Verfahren nach einem der Ansprüche 1 bis 12,
bei dem unter Verwendung der Fehleranalyse eine physikalische Analyse des physikalischen Objekts durchgeführt wird.

**14.** Vorrichtung zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben, mit einem Prozessor, der derart eingerichtet ist, dass folgende Verfahrensschritte durchgeführt werden:

- für die Fehlerdaten der Fehlerdatenmatrix werden Entwicklungskoeffizienten einer Analysetransformation der Fehlerdatenmatrix ermittelt,
- wobei die Analysetransformation eine Orthogonal-Transformation mit einer binären Struktur in den Basisvektor-Komponenten der Basisvektoren der Analysetransformation ist,
- unter Verwendung der ermittelten Entwicklungskoeffizienten der Analysetransformation wird die Fehleranalyse durchgeführt, wobei
- unter Verwendung der ermittelten Entwicklungskoeffizienten der Analysetransformation ein Maß für die Zufälligkeit der Verteilung der Fehler der physikalischen Teilobjekte ermittelt wird und
- unter Verwendung des Maßes für die Zufälligkeit der Verteilung der Fehler der physikalischen Teilobjekte bestimmt wird, ob ein systematisches Fehlermuster vorliegt.

**15.** Computerprogramm-Element, bei dem, wenn ein Computer es ausführt, der Computer folgende Schritte zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben, durchführt:

- für die Fehlerdaten der Fehlerdatenmatrix werden Entwicklungskoeffizienten einer Analysetransformation der Fehlerdatenmatrix ermittelt,
- wobei die Analysetransformation eine Orthogonal-Transformation mit einer binären Struktur in den Basisvektor-Komponenten der Basisvektoren der Analysetransformation ist,

- unter Verwendung der ermittelten Entwicklungskoeffizienten der Analysetransformation wird die Fehleranalyse durchgeführt, wobei
- unter Verwendung der ermittelten Entwicklungskoeffizienten der Analysetransformation ein Maß für die Zufälligkeit der Verteilung der Fehler der physikalischen Teilobjekte ermittelt wird und
- unter Verwendung des Maßes für die Zufälligkeit der Verteilung der Fehler der physikalischen Teilobjekte bestimmt wird, ob ein systematisches Fehlermuster vorliegt.

**16.** Computerlesbares Speichermedium, auf dem ein Programm gespeichert ist, bei dem, wenn ein Computer es ausführt, der Computer folgende Schritte zur Fehleranalyse von physikalischen Teilobjekten, welche in einem physikalischen Objekt in Form einer Matrix angeordnet sind, unter Verwendung einer Fehlerdatenmatrix mit Fehlerdaten, die Fehler der physikalischen Teilobjekte angeben, durchführt:

- für die Fehlerdaten der Fehlerdatenmatrix werden Entwicklungskoeffizienten einer Analysetransformation der Fehlerdatenmatrix ermittelt,
- wobei die Analysetransformation eine Orthogonal-Transformation mit einer binären Struktur in den Basisvektor-Komponenten der Basisvektoren der Analysetransformation ist,
- unter Verwendung der ermittelten Entwicklungskoeffizienten der Analysetransformation wird die Fehleranalyse durchgeführt, wobei
- unter Verwendung der ermittelten Entwicklungskoeffizienten der Analysetransformation ein Maß für die Zufälligkeit der Verteilung der Fehler der physikalischen Teilobjekte ermittelt wird und
- unter Verwendung des Maßes für die Zufälligkeit der Verteilung der Fehler der physikalischen Teilobjekte bestimmt wird, ob ein systematisches Fehlermuster vorliegt.

**Claims**

**1.** Method for error analysis of physical partial objects arranged in a physical object in the form of a matrix, using an error data matrix with error data specifying errors of the physical partial objects,

- in which development coefficients of an analysis transformation of the error data matrix are determined for the error data of the error data matrix,
- the analysis transformation being an orthogonal transformation with a binary structure in the basis vector components of the basis vectors of the analysis transformation,
- in which the error analysis is carried out using the determined development coefficients of the analysis transformation,
- a measure of the randomness of the distribution of the errors of the physical partial objects being determined using the determined development coefficients of the analysis transformation, and
- the measure of the randomness of the distribution of the errors of the physical partial objects being used to determine whether a systematic error pattern is present.

**2.** Method according to Claim 1,

- in which the physical object is a memory array, and
- a physical partial object is in each case a memory cell of the memory array or a part of a memory cell of the memory array.

**3.** Method according to Claim 1 or 2,
in which the analysis transformation is a normalized orthogonal transformation with a binary structure in the basis vector components of the basis vectors of the analysis transformation.

**4.** Method according to one of Claims 1 to 3,
in which the Walsh transformation is used as the analysis transformation.

**5.** Method according to one of Claims 1 to 4,

- in which the squares of the development coefficients of the analysis transformation are determined,
- in which the error analysis is carried out using the determined squares of the development coefficients of the analysis transformation.

**6.** Method according to Claim 5,

- in which the entropy of the error distribution of the physical partial objects is determined using the determined squares of the development coefficients of the analysis transformation,
- in which the error analysis is carried out using the determined entropy.

**7.** Method according to Claim 6,

- in which an empirical entropy of the error distribution of the physical partial objects is determined using the determined squares of the development coefficients of the analysis transformation,
- in which an analytical entropy of the error distribution of the physical partial objects is determined using the determined squares of the development coefficients of the analysis transformation,
- in which the error analysis is carried out in a manner dependent on the determined empirical entropy and the determined analytical entropy.

**8.** Method according to Claim 7,
in which the empirical entropy $S_{emp}$ of the error distribution of the physical partial objects is determined in accordance with the following specification:

$$S_{emp} = -\sum_{i=2}^{N} \alpha_i^2 \cdot \ln\left(\alpha_i^2\right),$$

where

- i designates a sequential index,
- $\alpha_i^2$ designates the square of the i-th development coefficient of the analysis transformation,
- N designates the number of physical partial objects taken into account.

**9.** Method according to Claim 7 or 8,
in which the analytical entropy $S_{ana}$ of the error distribution of the physical partial objects is determined in accordance with the following. specification:

$$S_{ana} = -\left[(1-r)^2 \ln(1-r)^2 + (1-(1-r))^2 \cdot \ln\frac{1-(1-r)^2}{N-2} \cdot (2.074 + \eta)\right]$$

where

- r designates a predeterminable random component where $0 \leq r \leq 1$, which specifies the randomness of the error distribution,
- N designates the number of physical partial objects taken into account, and
- $\eta$ designates a predetermined tolerance parameter.

**10.** Method according to Claim 7 or 8,
in which the analytical entropy $S_{ana}$ of the error distribution of the physical partial objects is determined in accordance with the following specification:

$$S_{ana} = -\left[f \cdot \alpha_{gen}^2 \cdot \ln\left(\alpha_{gen}^2\right) + (N-1-f) \cdot \alpha_{typ}^2 \cdot \ln\left(\alpha_{typ}^2 \cdot (2.074 + \eta)\right)\right]$$

where

$$\alpha_{typ}^2 = \frac{\left(1 - \alpha_1^2\right) \cdot \left(1 - (1 - r)^2\right)}{N - 1 - f},$$

$$\alpha_{gen}^2 = (1 - r)^2 \cdot \frac{\left(1 - \alpha_1^2\right)}{f},$$

$$\alpha_1 = (2 \cdot \delta - 1),$$

$$\delta = \frac{N_1}{N},$$

where

- $N_1$ designates the number of defective physical partial objects in the physical object,
- r designates a predeterminable random component where $0 \leq r \leq 1$, which specifies the randomness of the error distribution,
- f designates the number of Walsh patterns which were used to generate the initial state,
- N designates the number of physical partial objects taken into account, and
- $\eta$ designates a predetermined tolerance parameter.

**11.** Method according to Claim 5,

- in which a sum of a portion of the squares of the development coefficients, the values of the said squares being ordered in ascending fashion, is determined using the determined squares of the development coefficients of the analysis transformation,
- in which the error analysis is carried out using the determined sum.

**12.** Method according to Claim 11,
in which the error analysis is carried out using the determined sum and a further sum of a portion of the squares of the development coefficients, the values of the said squares being ordered in ascending fashion, in the case of essentially complete randomness of the error distribution.

**13.** Method according to one of Claims 1 to 12,
in which a physical analysis of the physical object is carried out using the error analysis.

**14.** Device for error analysis of physical partial objects arranged in a physical object in the form of a matrix, using an error data matrix with error data specifying errors of the physical partial objects, having a processor set up in such a way that the following method steps are carried out:

- development coefficients of an analysis transformation of the error data matrix are determined for the error data of the error data matrix,
- the analysis transformation being an. orthogonal transformation with a binary structure in the basis vector components of the basis vectors of the analysis transformation,
- the error analysis is carried out using the determined development coefficients of the analysis transformation,
- a measure of the randomness of the distribution of the errors of the physical partial objects being determined using the determined development coefficients of the analysis transformation, and
- the measure of the randomness of the distribution of the errors of the physical partial objects being used to determine whether a systematic error pattern is present.

**15.** Computer program element, in which, if a computer executes it, the computer carries out the following steps for error analysis of physical partial objects arranged in a physical object in the form of a matrix, using an error data matrix with error data specifying errors of the physical partial objects:

- development coefficients of an analysis transformation of the error data matrix are determined for the error data of the error data matrix,
- the analysis transformation being an orthogonal transformation with a binary structure in the basis vector components of the basis vectors of the analysis transformation,
- the error analysis is carried out using the determined development coefficients of the analysis transformation,
- a measure of the randomness of the distribution of the errors of the physical partial objects being determined using the determined development coefficients of the analysis transformation, and
- the measure of the randomness of the distribution of the errors of the physical partial objects being used to determine whether a systematic error pattern is present.

**16.** Computer-readable storage medium, on which a program is stored, in which, if a computer executes it, the computer carries out the following steps for error analysis of physical partial objects arranged in a physical object in the form of a matrix, using an error data matrix with error data specifying errors of the physical partial objects:

- development coefficients of an analysis transformation of the error data matrix are determined for the error data of the error data matrix,
- the analysis transformation being an orthogonal transformation with a binary structure in the basis vector components of the basis vectors of the analysis transformation,
- the error analysis is carried out using the determined development coefficients of the analysis transformation,
- a measure of the randomness of the distribution of the errors of the physical partial objects being determined using the determined development coefficients of the analysis transformation, and
- the measure of the randomness of the distribution of the errors of the physical partial objects being used to determine whether a systematic error pattern is present.

**Revendications**

**1.** Procédé d'analyse de défauts de parties d'objets physiques qui sont disposées dans un objet physique en forme de matrice en utilisant une matrice de données de défauts avec des données de défauts indiquant les défauts des parties d'objets physiques,

- dans lequel des coefficients de développement d'une transformation holomorphe de la matrice de données de défauts sont déterminés pour les données de défauts de la matrice de données de défauts,
- la transformation holomorphe étant une transformation orthogonale de structure binaire dans les composantes vectorielles de base des vecteurs de base de la transformation holomorphe,
- dans lequel l'analyse de défaut est effectuée en utilisant les coefficients de développement déterminés pour la transformation holomorphe,
- une mesure du caractère aléatoire de la distribution des défauts des parties d'objets physiques étant déterminée en utilisant les coefficients de développement déterminés pour la transformation holomorphe, et
- en utilisant la mesure du caractère aléatoire de la distribution des défauts des parties d'objets physiques, la présence éventuelle d'un type de défaut systématique est déterminée.

**2.** Procédé selon la revendication 1,

- dans lequel l'objet physique est un réseau de mémoire, et
- une partie d'objet physique est respectivement une cellule mémoire du réseau de mémoire ou une partie d'une cellule mémoire du réseau de mémoire.

**3.** Procédé selon la revendication 1 ou la revendication 2, dans lequel la transformation holomorphe est une transformation orthogonale normée de structure binaire dans les composantes vectorielles de base des vecteurs de base de la transformation holomorphe.

**4.** Procédé selon l'une des revendications 1 à 3, dans lequel la transformation de Walsh est utilisée en tant que transformation holomorphe.

**5.** Procédé selon l'une des revendications 1 à 4,

- dans lequel les carrés des coefficients de développement de la transformation holomorphe sont déterminés,
- dans lequel l'analyse de défauts est effectuée en utilisant les carrés déterminés des coefficients de développement de la transformation holomorphe.

**6.** Procédé selon la revendication 5,

- dans lequel l'entropie de la distribution des défauts des parties d'objets physiques est déterminée en utilisant les carrés déterminés des coefficients de développement de la transformation holomorphe,
- dans lequel l'analyse de défauts est effectuée en utilisant l'entropie déterminée.

**7.** Procédé selon la revendication 6,

- dans lequel une entropie empirique de la distribution des défauts des parties d'objets physiques est déterminée en utilisant les carrés déterminés des coefficients de développement de la transformation holomorphe,
- dans lequel une entropie analytique de la distribution des défauts des parties d'objets physiques est déterminée en utilisant les carrés déterminés des coefficients de développement de la transformation holomorphe,
- dans lequel l'analyse de défauts est effectuée en fonction de l'entropie empirique déterminée et de l'entropie analytique déterminée.

**8.** Procédé selon la revendication 7, dans lequel l'entropie empirique $S_{emp}$ de la distribution des défauts des parties d'objets physiques est déterminée suivant la règle ci-dessous :

$$S_{emp} = -\sum_{i=2}^{N} \alpha_i^2 \cdot \ln\left(\alpha_i^2\right),$$

où

- i est un indice variable,
- $\alpha_i^2$ est le carré du i$^{ème}$ coefficient de développement de la transformation holomorphe,
- N est le nombre des parties d'objets physiques considérées.

**9.** Procédé selon la revendication 7 ou la revendication 8, dans lequel l'entropie analytique $S_{ana}$ de la distribution des défauts des parties d'objets physiques est déterminée suivant la règle ci-dessous :

$$S_{ana} = -\left[(1-r)^2 \ln(1-r)^2 + (1-(1-r))^2 \cdot \ln\frac{1-(1-r)^2}{N-2} \cdot (2.074 + \eta)\right]$$

où

- r est une composante aléatoire prédéfinissable, avec $0 \leq r \leq 1$, indiquant le caractère aléatoire de la distribution des défauts,
- N est le nombre des parties d'objets physiques considérées, et
- $\eta$ est un paramètre de tolérance prédéfinissable.

**10.** Procédé selon la revendication 7 ou la revendication 8, dans lequel l'entropie analytique $S_{ana}$ de la distribution des défauts des parties d'objets physiques est déterminée suivant la règle ci-dessous :

$$S_{ana} = -\left[f \cdot \alpha_{gen}^2 \cdot \ln\left(\alpha_{gen}^2\right) + (N - 1 - f) \cdot \alpha_{typ}^2 \cdot \ln\left(\alpha_{typ}^2 \cdot (2.074 + \eta)\right)\right]$$

avec

$$\alpha_{typ}^2 = \frac{\left(1 - \alpha_1^2\right) \cdot \left(1 - (1 - r)^2\right)}{N - 1 - f},$$

$$\alpha_{gen}^2 = (1 - r)^2 \cdot \frac{\left(1 - \alpha_1^2\right)}{f},$$

$$\alpha_1 = (2 \cdot \delta - 1),$$

$$\delta = \frac{N_1}{N},$$

Où

- $N_1$ est le nombre de parties d'objets physiques défectueuses dans l'objet physique,
- r est une composante aléatoire prédéfinissable, avec $0 \leq r \leq 1$, indiquant le caractère aléatoire de la distribution des défauts,
- f est le nombre des motifs de Walsh qui ont été utilisés pour générer l'état de départ,
- N est le nombre des parties d'objets physiques considérées, et
- $\eta$ est un paramètre de tolérance prédéfinissable.

11. Procédé selon la revendication 5,

- dans lequel une somme d'une partie des carrés des coefficients de développement ordonnés par ordre de valeurs croissantes est déterminée en utilisant les carrés déterminés des coefficients de développement de la transformation holomorphe,
- dans lequel l'analyse de défauts est effectuée en utilisant la somme déterminée.

12. Procédé selon la revendication 11, dans lequel l'analyse de défauts est effectuée en utilisant la somme déterminée et une autre somme d'une partie des carrés des coefficients de développement ordonnés par ordre de valeurs croissantes avec un caractère quasi complètement aléatoire de la distribution des défauts.

13. Procédé selon l'une des revendications 1 à 12, dans lequel une analyse physique de l'objet physique est effectuée en utilisant l'analyse de défauts.

14. Dispositif d'analyse de défauts de parties d'objets physiques qui sont disposées dans un objet physique en forme de matrice en utilisant une matrice de données de défauts avec des données de défauts indiquant les défauts des parties d'objets physiques, comprenant un processeur agencé de façon à effectuer les étapes de procédé suivantes :

- des coefficients de développement d'une transformation holomorphe de la matrice de données de défauts sont déterminés pour les données de défauts de la matrice de données de défauts,
- la transformation holomorphe étant une transformation orthogonale de structure binaire dans les composantes

22

vectorielles de base des vecteurs de base de la transformation holomorphe,

- l'analyse de défauts est effectuée en utilisant les coefficients de développement déterminés pour la transformation holomorphe,
- une mesure du caractère aléatoire de la distribution des défauts des parties d'objets physiques étant déterminée en utilisant les coefficients de développement déterminés pour la transformation holomorphe, et
- la présence éventuelle d'un type de défaut systématique est déterminée en utilisant la mesure du caractère aléatoire de la distribution des défauts des parties d'objets physiques.

15. Elément de programme informatique, dans lequel, lorsqu'un ordinateur l'exécute, l'ordinateur effectue les étapes suivantes d'analyse de défauts de parties d'objets physiques qui sont disposées dans un objet physique en forme de matrice en utilisant une matrice de données de défauts avec des données de défauts indiquant les défauts des parties d'objets physiques :

- des coefficients de développement d'une transformation holomorphe de la matrice de données de défauts sont déterminés pour les données de défauts de la matrice de données de défauts,
- la transformation holomorphe étant une transformation orthogonale de structure binaire dans les composantes vectorielles de base des vecteurs de base de la transformation holomorphe,
- l'analyse de défauts est effectuée en utilisant les coefficients de développement déterminés pour la transformation holomorphe,
- une mesure du caractère aléatoire de la distribution des défauts des parties d'objets physiques est déterminée en utilisant les coefficients de développement déterminés pour la transformation holomorphe, et
- la présence éventuelle d'un type de défaut systématique est déterminée en utilisant la mesure du caractère aléatoire de la distribution des défauts des parties d'objets physiques.

16. Support de stockage lisible informatiquement sur lequel est stocké un programme dans lequel, lorsqu'un ordinateur l'exécute, l'ordinateur effectue les étapes suivantes d'analyse de défauts de parties d'objets physiques qui sont disposées dans un objet physique en forme de matrice en utilisant une matrice de données de défauts avec des données de défauts indiquant les défauts des parties d'objets physiques :

- des coefficients de développement d'une transformation holomorphe de la matrice de données de défauts sont déterminés pour les données de défauts de la matrice de données de défauts,
- la transformation holomorphe étant une transformation orthogonale de structure binaire dans les composantes vectorielles de base des vecteurs de base de la transformation holomorphe,
- l'analyse de défauts est effectuée en utilisant les coefficients de développement déterminés pour la transformation holomorphe,
- une mesure du caractère aléatoire de la distribution des défauts des parties d'objets physiques est déterminée en utilisant les coefficients de développement déterminés pour la transformation holomorphe, et
- la présence éventuelle d'un type de défaut systématique est déterminée en utilisant la mesure du caractère aléatoire de la distribution des défauts des parties d'objets physiques.

## FIG 1

100

101

109

111

106

110

108

113

105

107

114

104

103

102

112

115

116

118

117

119

120

## FIG 3

300

| Erstellen Bitmap | 301 |

↓

| Übermitteln Bitmap | 302 |

↓

| Speichern Bitmap | 303 |

↓

| Datentechnische Fehleranalyse | 304 |

↓

| Physikalische Überprüfung Chip abhängig von Ergebnis der datentechnischen Fehleranalyse | 305 |

# FIG 2A

X: 127 Y: 134

EP 1 265 255 B1

```
A LSB: 0 saw:  0 63  11111111111111111111111111111111111111111111111111111111111111  0
A LSB: 0 saw:  2 61  11111111111111111111111111111111111111111111111111111111111111  2
A LSB: 0 saw:  4 59  11111111111111111111111111111111111111111111111111111111111111  4
A LSB: 0 saw:  6 57  11111111111111111111111111111111111111111111111111111111111111  6
A LSB: 1 saw:  0 55  11111111111111111111111111111111111111111111111111111111111111  8
A LSB: 1 saw:  2 53  11111111111111111111111111111111111111111111111111111111111111  10
A LSB: 1 saw:  4 51  11111111111111111111111111111111111111111111111111111111111111  12
A LSB: 1 saw:  6 49  11111111111111111111111111111111111111111111111111111111111111  14
A LSB: 2 saw:  0 47  11111111111111111111111111111111111111111111111111111111111111  16
A LSB: 2 saw:  1 46  11111111111111111111111111111111111111111111111111111111111111  17
A LSB: 2 saw:  2 45  11111111111111111111111111111111111111111111111111111111111111  18
A LSB: 2 saw:  4 43  11111111111111111111111111111111111111111111111111111111111111  20
A LSB: 2 saw:  5 42  11111111111111111111111111111111111111111111111111111111111111  21
A LSB: 2 saw:  6 41  11111111111111111111111111111111111111111111111111111111111111  22
A LSB: 3 saw:  0 39  11111111111111111111111111111111111111111111111111111111111111  24
A LSB: 3 saw:  1 38  11111111111111111111111111111111111111111111111111111111111111  25
A LSB: 3 saw:  2 37  11111111111111111111111111111111111111111111111111111111111111  26
A LSB: 3 saw:  3 36  11111111111111111111111111111111111111111111111111111111111111  27
A LSB: 3 saw:  4 35  11111111111111111111111111111111111111111111111111111111111111  28
A LSB: 3 saw:  6 33  11111111111111111111111111111111111111111111111111111111111111  30
```

201

200

# FIG 2B

```
A LSB: 4 saw: 0  31  1111111111111111111111111111111111111111111111111111111111111111  32
A LSB: 4 saw: 1  30  1111....1111....1111....1111....1111....1111....1111....1111....  33
A LSB: 4 saw: 2  29  1111111111111111111111111111111111111111111111111111111111111111  34
A LSB: 4 saw: 3  28  1111....1111....1111....1111....1111....1111....1111....1111....  35
A LSB: 4 saw: 4  27  1111111111111111111111111111111111111111111111111111111111111111  36
A LSB: 4 saw: 5  26  1111....1111....1111....1111....1111....1111....1111....1111....  37
A LSB: 4 saw: 6  25  1111111111111111111111111111111111111111111111111111111111111111  38
A LSB: 4 saw: 7  24  1111....1111....1111....1111....1111....1111....1111....1111....  39
A LSB: 5 saw: 0  23  1111111111111111111111111111111111111111111111111111111111111111  40
A LSB: 5 saw: 1  22  11111111........11111111........11111111........11111111........  41
A LSB: 5 saw: 2  21  1111111111111111111111111111111111111111111111111111111111111111  42
A LSB: 5 saw: 3  20  11111111........11111111........11111111........11111111........  43
A LSB: 5 saw: 4  19  1111111111111111111111111111111111111111111111111111111111111111  44
A LSB: 5 saw: 5  18  11111111........11111111........11111111........11111111........  45
A LSB: 5 saw: 6  17  1111111111111111111111111111111111111111111111111111111111111111  46
A LSB: 5 saw: 7  16  11111111........11111111........11111111........11111111........  47
A LSB: 6 saw: 0  15  1111111111111111111111111111111111111111111111111111111111111111  48
A LSB: 6 saw: 1  14  1111111111111111................1111111111111111................  49
A LSB: 6 saw: 2  13  1111111111111111111111111111111111111111111111111111111111111111  50
A LSB: 6 saw: 3  12  1111111111111111................1111111111111111................  51
```

EP 1 265 255 B1

# FIG 2C

201    200

```
A LSB: 6 saw: 4 11  11111111111111111111111111111111111111111111111111111111111111111  52
A LSB: 6 saw: 5 10  1111111111111111.................1111111111111111..............  53
A LSB: 6 saw: 6  9  111111111111111111111111111111111111111111111111111111111111111111  54
A LSB: 6 saw: 7  8  1111111111111111.................1111111111111111..............  55
A LSB: 7 saw: 0  7  111111111111111111111111111111111111111111111111111111111111111111  56
A LSB: 7 saw: 1  6  11111111111111111111111111111..............................  57
A LSB: 7 saw: 2  5  111111111111111111111111111111111111111111111111111111111111111111  58
A LSB: 7 saw: 3  4  11111111111111111111111111111..............................  59
A LSB: 7 saw: 4  3  111111111111111111111111111111111111111111111111111111111111111111  60
A LSB: 7 saw: 5  2  11111111111111111111111111111..............................  61
A LSB: 7 saw: 6  1  111111111111111111111111111111111111111111111111111111111111111111  62
```

# FIG 4